# FASCICULE DE BREVET EUROPEEN

(11) **EP 3 311 428 B1**
(45) Date de publication et mention de la délivrance du brevet: **12.06.2019**
(21) Numéro de dépôt: 16731102.6
(22) Date de dépôt: 16.06.2016
(51) Int. Cl.: H01L 51/44, H01L 51/52, H01L 51/56, H01L 51/50

(54) **PROCÉDÉ DE RÉALISATION D'UN EMPILEMENT DU TYPE PREMIÈRE ÉLECTRODE / COUCHE ACTIVE / DEUXIÈME ÉLECTRODE**
VERFAHREN ZUR HERSTELLUNG EINES STAPELS MIT EINER ERSTEN ELEKTRODE/ EINER AKTIVEN SCHICHT/ EINER ZWEITEN ELEKTRODE
PROCESS TO REALISE A STACK COMPRISING A FIRST ELECTRODE/ AN ACTIVE LAYER/ A SECOND ELECTRODE

(30) Priorité: 16.06.2015 FR 1555480
(43) Date de publication de la demande: 25.04.2018
(73) Titulaire: Commissariat à l'Énergie Atomique et aux Énergies Alternatives, 75015 Paris (FR); ISORG, 38000 Grenoble (FR); Trixell, 38430 Moirans (FR)
(72) Inventeur: VERILHAC, Jean-Marie, 38500 Coublevie (FR); CHARLOT, Simon, 38100 Grenoble (FR)
(74) Mandataire: Collet, Alain
(86) Numéro de dépôt international: PCT/EP2016/063922
(87) Numéro de publication internationale: WO 2016/202938

(56) Documents cités:
- WO-A1-2013/190841
- WO-A1-2014/046539
- WO-A2-2007/004121
- FR-A1- 2 991 505
- JP-A- H1 154 286
- US-A1- 2011 312 120
- US-A1- 2012 126 277
- US-B1- 6 590 335

## Description

L'invention concerne les empilements de type conducteur/couche mince organique/conducteur, classiquement utilisés dans des dispositifs électroniques.

Ces dispositifs peuvent par exemple être des diodes redresseuses de courant, des cellules solaires, des cellules photodétectrices, des capacités, des diodes laser, des dispositifs types capteurs, des mémoires, des transistors, ou encore des diodes électroluminescentes. Il s'agit notamment de dispositifs de l'électronique organique sur substrat plastique souple.

L'invention s'applique plus particulièrement au domaine des empilements de diodes utilisés dans les cellules solaires organiques ou les photodétecteurs organiques.

Dans les dispositifs connus dans l'état de la technique, on peut constater l'apparition de courants de fuite électrique à travers la couche mince organique qui est censée isoler électriquement les deux électrodes conductrices, également appelée couche active.

Ces courants de fuite dépendent d'une part, des propriétés intrinsèques de la couche active, notamment sa conductivité, de la présence de pièges électriques, du positionnement des niveaux énergétiques HOMO-LUMO par rapport aux travaux de sortie des électrodes, ou de sa morphologie, et d'autre part, de paramètres extrinsèques comme les courants de fuite électrique parasites.

Ces courants parasites ne sont pas maîtrisés. Ils proviennent essentiellement de défauts topologiques, c'est-à-dire des trous ou des défauts morphologiques, c'est-à-dire des zones de volume libre plus important. Ils sont générés lors de la formation de la couche active.

Ainsi, la présence de trous dans la couche active peut conduire à court-circuiter localement les deux électrodes conductrices. Par ailleurs, les zones de morphologie différente sont plus propices au claquage électrique.

Ces défauts dans la couche active peuvent être dus aux matériaux utilisés pour former la couche, lesquels sont sous forme d'une solution pouvant comporter des agrégats, c'est-à-dire des parties du matériau mal dissoutes dans la solution. Ils peuvent également résulter de défauts présents sur le substrat, tels que des pics ou défauts topologiques de la surface ou des zones présentant des tensions de surface différentes.

Ces courants de fuite parasites sont très pénalisants lorsqu'ils surviennent dans des photodétecteurs organiques ou des diodes redresseuses de courant.

En effet, dans ce cas, le courant en régime inverse de la diode et dans le noir doit être très faible (de l'ordre du nA/cm²). Ainsi, la moindre fuite électrique à travers les défauts de la couche active peut faire augmenter ce courant de plusieurs décades et dégrader les performances de la diode de manière drastique et irréversible.

Ces courants de fuite parasites sont également pénalisants pour les cellules solaires organiques, mais dans une moindre mesure.

Pour un tel dispositif, plus le courant de fuite de la diode est faible et plus la cellule solaire pourra répondre à une faible illumination.

Ainsi, il a déjà été proposé des solutions pour minimiser les courants de fuite parasites dans la couche active d'un empilement.

Il a notamment été proposé d'augmenter l'épaisseur de la couche active, de filtrer les solutions avant leur dépôt pour former la couche active et d'utiliser des substrats présentant peu de défauts.

Cependant, les solutions proposées présentent des inconvénients.

En effet, une trop forte augmentation de l'épaisseur de la couche active tend par exemple à dégrader les performances des dispositifs. C'est pourquoi l'épaisseur de la couche active est généralement de l'ordre de 200-300 nm. Par ailleurs, une filtration nécessite une solution présentant une bonne solubilité ce qui n'est pas le cas de tous les matériaux actuellement disponibles pour les couches actives. De plus, l'étape de filtration est difficile à mettre en oeuvre au niveau industriel. Enfin, les substrats présentant peu de défauts sont des substrats avec des couches planarisantes qui sont d'un coût élevé.

On peut également citer le document FR-2991505 qui décrit un procédé de réalisation d'un empilement du type première électrode/couche active/deuxième électrode permettant de réduire les courants de fuite électriques parasites.

Ce procédé consiste tout d'abord à déposer une première couche de matériau conducteur sur un substrat, pour former la première électrode, puis une couche active, sous la forme d'une couche mince semi-conductrice organique, cette couche comportant des défauts.

Ce procédé consiste ensuite à éliminer localement, par attaque chimique, la première couche conductrice, à travers les défauts de la couche active.

Une deuxième couche de matériau conducteur est ensuite déposée sur la couche active, pour former la deuxième électrode conductrice.

Du fait de l'élimination locale de la couche conductrice, au niveau des défauts de la couche active, les deux électrodes ne peuvent plus être en contact et de ce fait, ne peuvent pas créer de court-circuit électrique à travers la couche active. Les courants de fuite électriques sont donc considérablement réduits.

Ce procédé permet donc de réduire les risques de court-circuits.

Cependant, il n'est pas adapté dans le cas où la deuxième couche conductrice est très liquide. En effet, elle est alors susceptible de s'infiltrer sous la couche organique et de rentrer en contact avec la première couche conductrice au-delà de la zone gravée sous le défaut.

De plus, le procédé nécessite que la première couche conductrice soit totalement gravée au niveau des défauts afin d'éviter un court-circuit. Ainsi, pour être efficace, le procédé nécessite que la première couche conductrice soit largement surgravée par rapport à la dimension de l'ouverture dans la couche active, car lorsque la deuxième couche conductrice est déposée, elle s'infiltre un peu sous la couche active et peut ainsi générer un court-circuit.

Le document US2011/0312120 décrit une méthode de réparation de défauts dans des films minces dans laquelle les trous créés par des défauts dans la couche active sont remplis par un matériau isolant.

Le document US2012/0126277 décrit un dispositif électroluminescent dans lequel un défaut présent dans la couche électroluminescente est rempli par un matériau isolant.

Le document US6590335 décrit une méthode de réparation pour un dispositif électroluminescent dans laquelle des parties de l'électrode supérieure métallique sont retirées par faisceau laser au niveau des défauts dans la couche active.

Ainsi, l'invention a pour objet de réduire encore les courants de fuite électriques parasites à travers la couche active d'un empilement du type conducteur/couche active/conducteur, tout en maintenant les performances des dispositifs correspondants.

L'invention a pour objet un procédé de réalisation d'un empilement du type première électrode/couche active/deuxième électrode destiné à un dispositif électronique notamment du type photodétecteur organique ou cellule solaire organique, tel que décrit dans la revendication 1.

Dans une première variante, le procédé comporte une étape (i) supplémentaire consistant à retirer la résine après l'étape (h) de gravure.

Dans une autre variante, le procédé comporte une étape supplémentaire consistant à déposer une couche de passivation sur la deuxième électrode conductrice, avant l'étape (d) de dépôt de la couche de résine.

Dans un mode particulier de mise en oeuvre du procédé selon l'invention, une étape (c) d'élimination locale par attaque chimique de la première couche conductrice, à travers les zones non continues de la couche active est prévue après l'étape (b).

L'invention sera mieux comprise et d'autres buts, avantages et caractéristiques de celle-ci apparaîtront plus clairement à la lecture de la description qui suit et qui est faite au regard des dessins annexés sur lesquels :
- les figures 1 et 2 sont des vues en coupe, représentant les étapes (a) à (c) du procédé selon l'invention,
- les figures 3 à 6 sont des vues en coupe, représentant les étapes (d) à (g) d'un premier mode de mise en oeuvre, non conforme à la présente invention
- les figures 7 à 12 sont des vues en coupe, représentant les étapes d'une première variante du premier mode de mise en oeuvre du procédé illustré aux figures 3 à 6,
- les figures 13 à 18 sont des vues en coupe et représentent les étapes (d) à (h) du deuxième mode de mise en oeuvre selon l'invention,
- les figures 19 à 24 sont des vues en coupe, représentant les étapes (d) à (k) d'un troisième mode de mise en oeuvre non conforme à présente invention,
- les figures 25 à 28 sont des vues en coupe, représentant les étapes d'une variante du troisième mode de mise en oeuvre du procédé,
- la figure 29 est une vue de dessus d'un détail de la figure 2,
- la figure 30 est une vue en coupe illustrant une matrice de pixels obtenue par le deuxième mode de mise en oeuvre du procédé selon l'invention,
- la figure 31 est une vue de dessus d'une matrice de pixels obtenue par le deuxième mode de mise en oeuvre du procédé selon l'invention,
- les figures 32 à 34 sont des vues en coupe représentant une variante du deuxième mode de mise en oeuvre du procédé selon l'invention pour l'obtention d'une matrice de pixels.

Les éléments communs aux différentes figures seront désignés par les mêmes références.

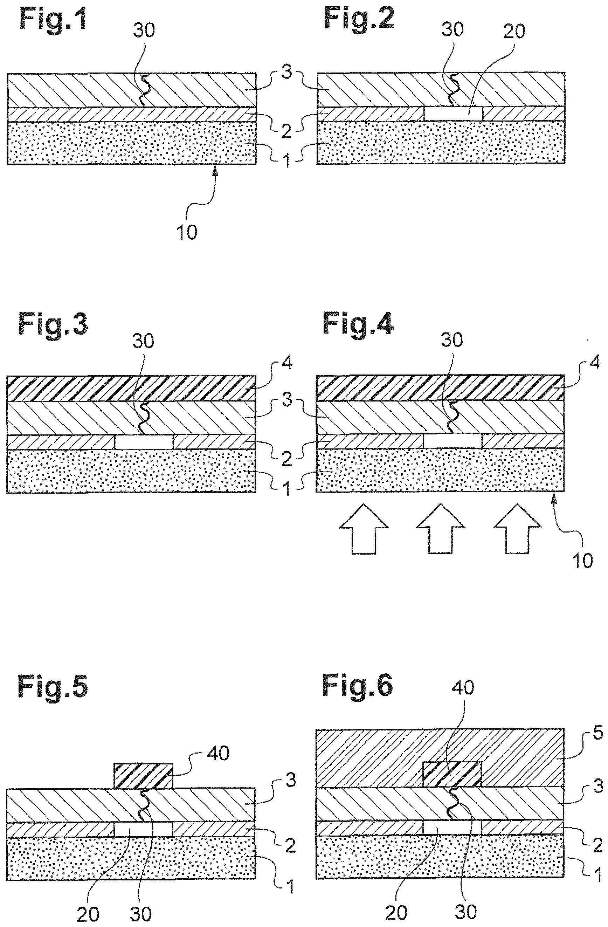

Les étapes (a) à (c) du procédé selon l'invention vont être décrites en référence aux figures 1 à 3. Elles sont communes à tous les modes de mise en oeuvre du procédé.

La figure 1 illustre un substrat 1 qui peut être rigide ou souple.

Il doit présenter une transmittance d'au moins 20% à la longueur d'onde d'insolation de la résine qui sera utilisée dans la suite du procédé. De façon générale, le procédé peut utiliser tout type de substrat non entièrement opaque à la longueur d'onde de cette résine

De préférence, cette transmittance est d'au moins 40%, voire d'au moins 70%, à cette longueur d'onde.

Il s'agit, par exemple, d'un substrat rigide en verre ou du type FOP (Fiber On Plate dans la terminologie anglosaxone), ou d'un substrat flexible en matière plastique, par exemple du type PET.

Sur le substrat 1, a été déposée, lors d'une étape (a), une couche 2 d'un matériau conducteur. Cette couche 2 formera la première électrode conductrice.

Cette électrode doit être opaque à la longueur d'onde de la résine utilisée dans la suite du procédé.

De façon générale, elle est opaque dans la gamme d'insolation des résines utilisées. Les longueurs d'onde correspondantes sont situées dans la gamme des UV (UVA, UVB, UVC). On notera que la longueur d'onde de 365 nm correspond à la longueur d'onde d'insolation utilisée pour les résines les plus utilisées en photolithographie.

On comprend ici par le terme « électrode opaque », une électrode qui présente une transmittance inférieure à 20% à la longueur d'onde utilisée pour insoler la résine. Cette transmittance est, de préférence, inférieure à 10%, voire à 5% à cette longueur d'onde.

L'épaisseur de cette couche 2 est comprise entre 1 nm et plusieurs microns mètres. De préférence, elle sera strictement supérieure à 5 nm et inférieure à 500 nm.

Cette couche 2 peut être constituée d'une seule couche ou d'un multicouche avec des couches d'interface spécifiques.

Le matériau de la couche 2 peut être un métal, par exemple Au, Pd, Pt, Cr, Ti, Al ou TiW.

La couche métallique peut être une couche massive.

Dans ce cas, l'épaisseur de la couche est de préférence strictement supérieure à 5 nm.

Le matériau de la couche 2 peut également être un oxyde conducteur avec un transmittance dégradée dans les UVA, ou avec une faible transmittance naturelle dans les UVB ou UVC: par exemple ITO, AZO, TiO₂ dopé Nb, FTO, GZO ou IZO.

On peut envisager plusieurs types de multicouches.

Il peut tout d'abord s'agir d'un empilement d'oxyde conducteur ou semi-conducteur : par exemple ITO/TiOx, AZO/TiOx, ITO/MoO₃, ITO/V₂O₅, AZO/ZnO ou FTO/NiO.

On peut également envisager un empilement d'au moins deux couches réalisées en un métal et un oxyde métallique. Les combinaisons suivantes peuvent être par exemple envisagés : Cr/ZnO, Au/TiO₂, Au, MoO₃ ou Cr/WO₃.

En particulier, il peut s'agir d'un empilement de trois couches, par exemple du type : ITO/Ag/ITO, AZO/Ag/AZO ou ZnO/Ag/ZnO.

Dans ce cas, les épaisseurs de l'empilement sont ajustées de façon à moduler le spectre optique de l'empilement et, en particulier, pour couper à la longueur d'onde visée pour l'insolation de la résine. Par exemple, les simulations optiques sur Optilayer, montrent qu'un empilement tri-couche de type AZO/Ag/AZO avec des épaisseurs de 300 nm/10 nm/300 nm aurait une transmittance de 17% à 365 nm, alors qu'un empilement avec des épaisseurs de 600 nm/10 nm/600 nm aurait une transmittance de 4% à 365 nm. Il est donc possible de moduler l'épaisseur afin de faire en sorte que le tri-couche coupe à la bonne longueur d'onde. Il est aussi envisageable d'utiliser plus de trois couches pour faire un miroir de Bragg qui coupe à la longueur d'onde désirée.

La couche 2 est également constituée d'un empilement d'une couche de métal et d'une couche en un matériau organique pour moduler son travail de sortie. On rappelle ici que le travail de sortie d'un métal est l'énergie nécessaire pour extraire les électrons de la couche ou encore les faire passer de leur état lié dans le métal à un état non lié qui correspond à l'énergie du vide.

La matériau organique peut être du PEI, du PEIE, un polyélectrolyte conjugué (poly[9,9-bis(3'-(N,N-dimethylamino)propyl)-2,7-fluorene-alt-2,7-(9,9-dioctylfluorene)] (PFN)) ou non (Nafion) ou une SAM (couche auto assemblée).

La couche 2 peut être déposée par des techniques classiques sous vide, par exemple par évaporation ou pulvérisation cathodique. Elle peut également être déposée par voie liquide par exemple par une technique d'impression de type sérigraphie, sous forme atomique ou sous forme de dispersion de particules. D'autres techniques de dépôt par voie liquide sont par exemple l'enduction centrifuge, mieux connue sous son nom anglais de : « spin-coating », l'enduction à filière plate mieux connue sous son nom anglais de : « slot-die », l'héliographie, la flexographie, le jet d'encre, le dépôt par raclage, étalement à la lame, mieux connu sous son nom anglais de : « doctor blade » ou encore l'enduction par trempage mieux connue sous son nom anglais de : « dip-coating ». Dans la suite de la description, les termes anglais seront à nouveau utilisés.

De façon générale, cette première électrode 1 pourra faire office d'anode ou de cathode.

De plus, elle doit pouvoir être gravée par voie liquide ou vapeur, à travers les défauts traversants de la couche active, sans impacter ou en impactant faiblement les propriétés de cette couche active. La couche 2 est généralement une couche qui est localisée spatialement.

La figure 1 montre que, sur la couche 2, est déposée une couche active 3, lors d'une étape (b).

L'épaisseur de cette couche 3 est de préférence comprise entre 10 nm et plusieurs micromètres.

Dans le cas des photodétecteurs organiques et des cellules solaires organiques, la couche active est constituée d'au moins un matériau qui est de nature semi-conducteur.

Elle est avantageusement constituée d'un mélange d'un matériau donneur d'électrons et d'un matériau accepteur d'électrons. Le matériau semi-conducteur donneur peut être une molécule, un oligomère ou un polymère organique π conjugué, c'est-à-dire avec une alternance de liaisons simples et de liaisons double. Le mélange classiquement utilisé est le couple poly(3-hexylthiophène) régiorégulier (P3HT RR) et le [6,6]-Phényl C61 butyric acid methyl ester ([60]PCBM). D'autres polymères donneurs à fort gap (PFB, TFB, PTAA, PCDTBT, etc...) ou à faible gap (PDPP3T, PCPDTBT, Si-PCPDTBT, PDDTT, etc...) pourront avantageusement être utilisés. De même, pour le matériau accepteur, d'autres matériaux peuvent avantageusement être utilisés, du type dérivés du C60, C70 ou C80 (PCBM, indène-C60, indene-C60 bis adduct), molécules de type acène diimide, ou polymère (F8BT, N2200) ou tout autre composé inorganique.

Ainsi, la couche active peut être une hétérojonction d'un matériau donneur d'électrons et d'un matériau accepteur d'électrons se présentant sous la forme d'une couche ou d'un empilement de plusieurs couches. Il peut également s'agir d'un mélange à l'échelle nanométrique des deux matériaux sous la forme d'hétérojonction en volume, c'est-à-dire d'un mélange intime des deux matériaux à l'échelle nanométrique.

La couche 3 peut être déposée selon une couche continue ou localisée spatialement.

La couche active peut être déposée par évaporation ou co-évaporation, (cas des molécules de faibles masses molaires) ou par voie liquide (matériaux sous forme de molécules, oligomères et polymères). De manière non exhaustive, les techniques de dépôt par voie liquide sont de type spin-coating, slot-die, héliographie, flexographie, sérigraphie, jet d'encre, doctor blade ou encore dip-coating.

Dans certains cas, la couche active pourra être réticulée afin de la rendre insoluble dans les solvants présents dans les différentes couches déposées et/ou utilisés lors des différentes étapes de gravure prévues dans le procédé.

Plusieurs voies peuvent être utilisées pour réticuler la couche active. Ces voies sont bien décrites dans le document suivant : Guillaume Wantz et al, Polym Int, 63 (2014) 1346-1361.

Par exemple, le P3HT et le PCBSD peuvent être mélangés dans un ratio massique de 1:1 et déposés à une épaisseur de 200 nm. La couche est ensuite recuite à 160°C pendant 30 min afin de devenir insoluble dans les solvants usuels.

De façon générale, cette couche active 3 devra présenter une transmittance supérieure à 5% à la longueur d'onde de la résine qui sera utilisée dans la suite du procédé.

De préférence, cette transmittance est d'au moins 20%, voire d'au moins 50%, à cette longueur d'onde.

Comme indiqué précédemment, la couche active 3 comporte des zones non continues, ou encore des défauts, référencés 30 sur la figure 1.

Ces défauts peuvent consister en des trous micrométriques ou en des zones présentant des volumes libres importants. Il peut s'agir de porosité ou encore de volumes qui ne sont pas occupés par les chaines polymères. Ils présentent des dimensions comprises entre 1 nm et plusieurs 100ènes de microns.

La figure 2 illustre une autre étape (c) du procédé au cours de laquelle la couche conductrice 2 est éliminée localement à travers les défauts 30.

Comme cela sera expliqué ultérieurement, cette étape (c) pourra, en pratique, être omise.

Cette élimination locale sera obtenue par une technique de gravure de préférence en voie humide, c'est-à-dire par mise en contact avec une solution de gravure. Dans un cas particulier de l'invention, la gravure pourra être réalisée en exposant l'échantillon à des vapeurs de la solution de gravure. Dans certains cas, cette élimination est obtenue avec un solvant. C'est cependant le terme de solution de gravure qui sera généralement utilisé dans la suite de la description.

Bien entendu, la solution de gravure doit être choisie de façon à ne pas dégrader les propriétés électriques, optiques et mécaniques de la couche active. Les propriétés électriques de la couche active peuvent être dégradées du fait d'une augmentation ou d'une diminution de sa conductivité, ou encore de la génération de pièges électriques intrinsèques ou extrinsèques à la couche active. La dégradation des propriétés optiques de la couche active peut par exemple se traduire par une diminution des propriétés d'absorption de la lumière à la longueur d'onde désirée. Enfin, la dégradation des propriétés mécaniques peut se traduire notamment par un décollement, une fissuration ou une perte de flexibilité de la couche active.

Ainsi, de façon générale, la solution de gravure utilisée sera sélective, c'est-à-dire qu'elle pourra graver la couche conductrice 2, sans pour autant graver ou attaquer la couche active 3.

De façon générale, la solution de gravure sera un acide ou une base. Elle pourra être pure ou encore diluée dans l'eau ou dans un solvant orthogonal à la couche active, c'est-à-dire un solvant non susceptible d'attaquer ou de dissoudre la couche active. Un solvant orthogonal peut être du type méthanol, éthanol, éthylène glycol, di-éthylène glycol, ou encore isopropanol.

De façon préférée, la solution de gravure sera diluée dans l'eau et, de préférence, dans de l'eau désionisée pour éviter la contamination éventuelle par des ions, notamment métalliques (Na+, etc...).

L'homme du métier sait choisir la nature et la concentration de l'acide fort (du type HNO₃, HCl, H₂SO₄, Kl, acide oxalique ou encore H₃PO₄) ou faible (du type acide oxalique, CH₃CO₂H ou NH₄+), ou encore de la base forte (du type NaOH ou KOH) ou faible (du type NH₃ ou CH₃CO₂-), en fonction de la nature de l'électrode conductrice et de la vitesse de gravure. Il est notamment fait référence, à cet égard, à l'ouvrage « Thin Film Processes » édité par John L. Vossen and Werner Kern, Academic Press, New York, 1978.

De façon générale, la vitesse de gravure est comprise entre 1 et 1 000 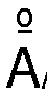 /s.

La solution de gravure est apportée sur la couche active 3 et elle pénètre à travers les zones non continues 30 de cette couche active. La solution de gravure peut être apportée sur toute la surface de la couche active ou de manière localisée. On peut mettre en oeuvre un dépôt localisé dans le cas où plusieurs dispositifs différents sont sur la même matrice, certains d'entre eux étant sensibles à la solution de gravure.

La solution de gravure atteint alors la couche conductrice 2 à travers les zones 30, ce qui permet d'éliminer localement la couche 2, dans les zones identifiées 20 sur la figure 2.

Suivant la composition de l'électrode 2, cette dernière pourra être gravée en une étape ou plusieurs étapes et avec une ou plusieurs solutions de gravure différentes.

La gravure se fait généralement de manière concentrique à partir du défaut dans la couche active.

De façon générale, la durée de la gravure sera choisie de telle sorte que la surface de la zone gravée ou ouverture 20 dans la couche 2, à travers un défaut 30 de la couche active 3, soit au moins égale à la surface de ce défaut. Les surfaces sont ici mesurées dans le plan des couches 2 et 3.

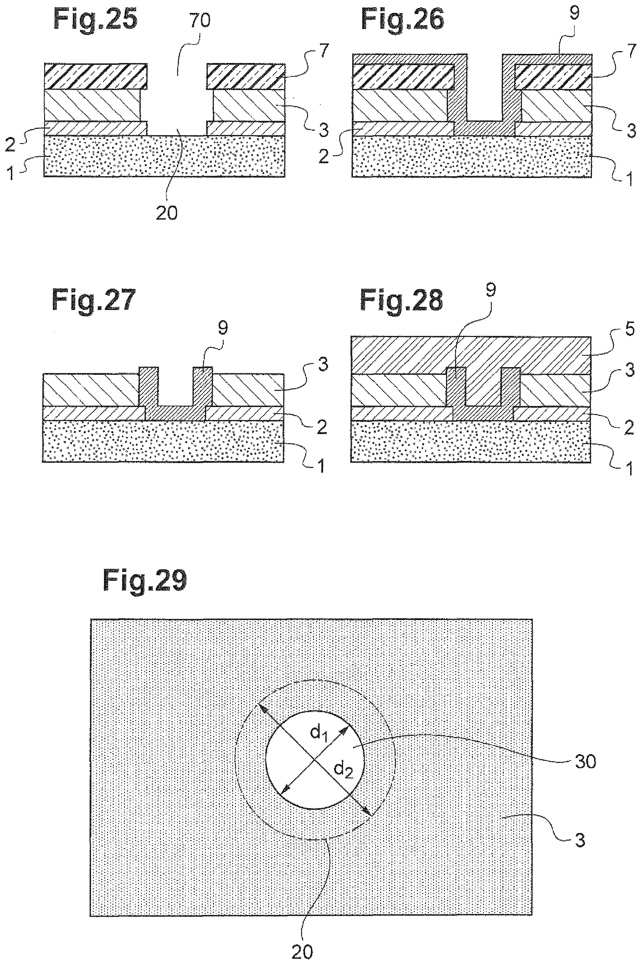

Ceci est illustré par la figure 29 qui montre, vue de dessus, la couche 3, au niveau d'un défaut 30. Il s'agit ici d'un trou micrométrique dont l'entrée est schématiquement représentée par un disque. Ce dernier présente un diamètre d₁.

Par ailleurs, la figure 29 montre, délimitée par un trait pointillé, la zone 20 de la couche 2 qui a été gravée et qui est donc dépourvue de matériau conducteur. Cette zone 20 est schématiquement représentée sous la forme d'un disque de diamètre d₂ qui est supérieur à d₁.

Ainsi, dans le cas d'un trou, d₂ est au moins égal à d₁ et il sera de préférence égal à au moins 2 d₁, voire 5 d₁.

Bien entendu, la zone non continue 30 peut présenter une forme différente de celle d'un disque. Il peut notamment s'agir d'une fissure allongée.

Dans tous les cas, la zone 20 présente au moins les dimensions du défaut et de préférence, une dimension au moins 2 fois voire 5 fois plus importante.

Il convient encore de noter que, lorsque la couche 2 se présente sous la forme d'un empilement de plusieurs couches de matériaux différents, des solutions de gravure différentes pourront également être utilisées successivement, de façon à pouvoir graver complètement l'ensemble de la couche 2.

Une fois la gravure terminée, l'empilement illustré à la figure 2 sera rincé, de façon à stopper la réaction de gravure et à éliminer d'éventuelles traces résiduelles de solution de gravure dans la couche active 3.

Cette étape de rinçage sera réalisée par trempage dans au moins un bain d'eau désionisée, d'un solvant orthogonal ou encore d'un mélange eau/solvant orthogonal. Dans une variante, la solution de rinçage pourra être légèrement acide (si l'attaque chimique préalable est basique) et vice-versa afin de tamponner le pH de la solution lors du rinçage.

Bien entendu, le rinçage de l'empilement peut également être réalisé par projection d'un liquide approprié, en variante d'un trempage dans un bain.

A titre d'exemple, une électrode 2 réalisée en oxydes conducteurs de type ZnO dopé aluminium (AZO) ou de type multi-couches (AZO/Ag/AZO...) pourra être avantageusement utilisée du fait de sa facilité à être gravée (une épaisseur de 125 nm peut être gravée en moins de 30 s dans une solution de gravure à 50°C) dans des solutions aqueuses diluées d'HCl ou HCl/FeCl₃ (notamment commercialisées sous la dénomination : TE100 du fabricant Transene).

Les différents modes de mise en oeuvre du procédé vont maintenant être détaillés.

Il est tout d'abord fait référence aux figures 3 à 6 relatives aux étapes supplémentaires du premier mode de mise en oeuvre du procédé, non conforme à la présente invention.

Ainsi, la figure 3 illustre une autre étape (d) de ce premier mode de mise en oeuvre du procédé, dans laquelle une couche 4 d'une résine négative est déposée sur la couche active 3.

Par convention et définition, une résine négative est une résine qui reste en place dans les zones insolées, et une résine positive est une résine qui part dans les zones insolées.

L'épaisseur de cette couche 4 est comprise entre 10 nm et 100 µm et, de préférence, entre 0,2 µm et 5 µm.

De manière générale, l'épaisseur de cette couche 4 doit être suffisante pour recouvrir la topologie des défauts sur la couche active.

Cette résine peut être une résine fluorée, par exemple une résine commercialisée sous la dénomination OSCoR4000 du fabricant Orthogonal. Cette résine peut être une résine non-fluorée de la gamme des SU8.

La résine peut être déposée sur la couche active 3 par évaporation ou, de préférence, par voie liquide. De préférence, cette résine sera déposée par slot-die, spin-coating ou spray-coating.

La figure 4 illustre une autre étape (e) au cours de laquelle la résine est insolée à travers la face arrière 10 du substrat. En conséquence, elle sera insolée dans les zones correspondant à celles où l'électrode 2 n'est pas présente et notamment dans les zones 20 dans laquelle l'électrode 2 a été gravée, comme expliqué au regard de la figure 2.

Les gammes de doses d'insolation sont celles recommandées dans les fiches techniques des résines et sont typiquement de l'ordre de 50-100 mJ. De manière préférentielle, la dose pour réticuler la résine sera ajustée en fonction de la transmittance des couches sous-jacentes (substrat 1, électrode 2, couche active 3) à la longueur d'onde d'insolation de la résine.

De préférence, l'insolation aura lieu en atmosphère inerte, avec un taux limité d'oxygène, afin de limiter la photooxydation de la couche active.

La figure 5 illustre une étape suivante (f) du procédé au cours de laquelle sont développées les zones de la couche 4 de résine qui n'ont pas été insolées. Ce développement est réalisé grâce à un développeur qui doit être orthogonal aux couches sous-jacentes et, en particulier, à la couche active 3. En d'autres termes, les composantes de ce développeur ne dissolvent pas ou très peu les couches sous-jacentes.

A titre d'exemple, pour une résine du type SU8, le développeur pourra être un produit commercialisé par MicroChem sous la dénomination SU-8 Developer qui est à base de PGMEA. Pour une résine commercialisée sous la dénomination OSCoR4000, le développeur pourra être un produit commercialisé sous la dénomination Orthogonal Developer 103 Solution par la société Orthogonal.

La figure 5 montre qu'après cette étape (f) de développement, sont obtenus des plots 40 de résine négative qui sont situés au-dessus des zones 20 gravées de la couche 2 et donc, au-dessus des défauts 30 présents dans la couche active 3. Ces plots 40 de résine négative permettent de passiver électriquement les zones non continues ou de défauts 30, c'est-à-dire d'isoler électriquement ces zones 30 susceptibles de créer des courants de fuite électriques dans l'empilement.

La figure 6 illustre l'étape (g) dans laquelle est déposée une couche 5 d'un matériau conducteur qui formera la deuxième électrode conductrice.

Cette deuxième électrode 5 pourra faire office d'anode ou de cathode.

L'épaisseur de cette couche 5 est comprise entre 5 nm et 500 µm, de préférence entre 8 nm et 30 µm.

Pour certaines applications qui nécessitent une absorption par le haut de l'empilement, cette couche 5 sera semi-transparente. Elle peut également être opaque.

Ainsi, lorsque l'empilement est destiné à former une photodiode, cette dernière peut absorber les photons à travers cette électrode.

On comprend ici par le terme «électrode semi-transparente » une électrode qui présente une transmisttance supérieure à 10% à la longueur d'onde désirée d'absorption de la photodiode. Cette transmittance est, de préférence, supérieure à 40%, voire 70%, à cette longueur d'onde.

Cette électrode 5 peut être formée par un matériau organique, inorganique ou un mélange des deux.

Ainsi, cette couche 5 pourra se présenter sous la forme d'une monocouche d'un de ces matériaux, d'un mélange à base de plusieurs de ces matériaux ou encore d'un empilement de couches de ces différents matériaux, seuls ou en mélange, avec des couches d'interface spécifiques.

Elle pourra être déposée par les mêmes techniques que celles utilisées pour le dépôt de la couche 2.

A titre d'exemple, l'électrode 5 peut être une monocouche ou un multicouche comprenant au moins une des couches suivantes : des métaux (par exemple Ca, Ba, Au, Al, Ag, Pd, Pt, Ti ou TiW), avec une épaisseur inférieure à 10 nm dans le cas où l'électrode doit être semi-transparente, des oxydes métalliques sous forme de monocouches (par exemple ITO, GZO, AZO ou ZnMgO) ou de tricouches (par exemple ITO/Ag/ITO, ZnO/Ag/ZnO ou AZO/Ag/AZO), des polymères conducteurs de type PANI, PEDOT/PSS ou Plexcore OC1100, des matériaux conducteurs carbonés de type graphène ou nanotubes de carbone.

Les matériaux précédemment décrits pourront être sous forme de films continus ou de réseaux percolant de nanofils (par exemple : nanofils d'Ag, de Cu, d'Au ou d'ITO).

Des couches d'interface pourront éventuellement être déposées avant l'électrode 5 afin par exemple de caler son travail de sortie.

A titre d'exemple, pour que le dispositif final ait un comportement de diode, il faut préférentiellement que les électrodes 2 et 5 aient des travaux de sortie différents. Pour cela on se sert, soit du travail de sortie de la couche conductrice utilisée, soit on place une couche d'interface qui va moduler le travail de sortie de l'électrode afin de caler ce même travail de sortie à la valeur désirée pour le dispositif.

On peut citer à titre d'exemple de couche d'interface : LiF, Ca, Ba, avec des épaisseurs inférieures à 5 nm ; PEI ou PEIE, oxydes métalliques (TiOₓ, ZnOₓ, MoO₃, CsCO₃, WO₃), polyelectrolytes conjugués (PFN) ou du Nafion.

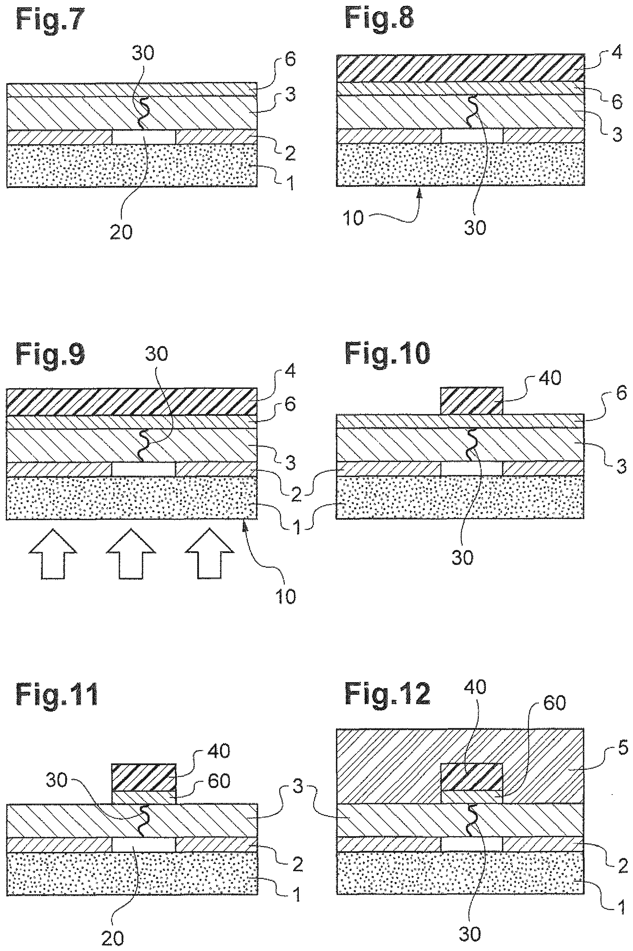

Dans une variante du premier mode de mise en oeuvre du procédé illustrée sur les figures 7 à 12, une couche de passivation 6 est déposée sur la couche active entre les étapes (c) et (d) précédemment décrites au regard des figures 2 et 3.

Les figures 7 et 8 montrent que cette couche tampon ou de passivation 6 est déposée entre la couche active 3 et la couche de résine 4. Cette couche 6 sert à protéger la couche active 3 de la résine. Cette couche 6 est de nature isolante électriquement.

Elle peut être déposée par voie liquide ou par évaporation.

Elle a une épaisseur comprise entre 1 nm et 20 µm.

Elle peut être par exemple du Parylène ®, une couche d'oxyde faite par ALD (oxyde métallique type Al₂O₃, Nitrure métallique type SiN) ou un polymère fluoré du type commercialisé sous la dénomination Cytop® par la société ASAHI.

Les figures 9 et 10 illustrent les étapes (e) et (f) d'insolation et de développement de la résine qui sont identiques à celles décrites au regard des figures 4 et 5.

Cette couche 6 est ensuite gravée par voie liquide ou par plasma, après les étapes (e) et (f) d'insolation et de développement de la résine.

Cette étape de gravure est illustrée par la figure 11.

La couche 6 ainsi présente sous les plots 40 de résine qui surplombent les zones de défauts 30.

La figure 12 illustre l'étape (g) de formation de la deuxième électrode conductrice qui est identique à celle décrite au regard de la figure 6.

Un premier exemple de ce premier mode de mise en oeuvre du procédé va maintenant être décrit.

Il permet de réaliser des photodiodes organiques sur un substrat rigide en verre.

La première électrode 2 est réalisée en aluminium et présente une épaisseur de 100 nm.

Elle est déposée par pulvérisation cathodique puis localisée avec les techniques standards de la microélectronique. L'électrode 2 est ensuite décapée à l'aide d'un traitement plasma RIE.

Une couche active 3 de type hétérojonction volumique d'une épaisseur de 150 nm est déposée sur toute la surface de l'électrode 2 par spin-coating, ou par d'autres techniques d'impression du type slot die, sérigraphie, héliogravure, jet d'encre ou spray.

La couche active est un mélange donneur/accepteur, le donneur pouvant être un polymère conjugué de type poly(3-hexylthiophène) régiorégulier et l'accepteur une molécule de type dérivée du fullerene de type 60PCBM. Le donneur et l'accepteur ont un ratio de 1:1 dans le mélange.

L'empilement est ensuite trempé dans une solution de gravure de l'Aluminium (par exemple Alu Etch 1960 de Fujifilm (25 vol H₃PO₄ + 1 vol HNO₃ + 5 vol CH₃COOH + H₂O) à une température de 60°C, la vitesse de gravure étant de v=7nm/s)

La couche 3 est ensuite rincée abondamment à l'eau désionisée, puis séchée.

Une résine 4 du type commercialisée sous la dénomination OSCoR4000 par Orthogonal est déposée par spin-coating sur la couche active 3 pour obtenir une épaisseur de 1 µm. La couche de résine 4 obtenue est recuite à 90°C pendant 1 min. Elle est ensuite insolée par la face arrière 10 du substrat, avec une longueur d'onde de 365 nm et une dose de 100 mJ/cm². Une étape dite de post-back de 1 min à 90°C est réalisée Elle permet de finir de bien durcir la résine dans les zones insolées de façon à ce qu'elle ne parte pas lors de l'étape de développement.

La couche 4 de résine est ensuite développée dans les zones non insolées, pendant 90 s et à l'aide du développeur commercialisé sous la dénomination « Developer 103 » fourni par Orthogonal.

En dernier lieu, la deuxième électrode 5 (anode) est déposée. Elle comporte une couche d'interface de 100 nm en PEDOT-PSS, sur laquelle est déposée une couche d'Ag évaporée dont l'épaisseur est de 8 nm.

Dans un autre exemple du premier mode de mise en oeuvre du procédé, le substrat 1 est un substrat souple en PET.

De plus, la première électrode 2 (la cathode) est composée de deux couches : une première couche conductrice opaque en Cr d'une épaisseur de 100 nm, et une deuxième couche, dite couche d'interface, en ZnO d'une épaisseur de 30 nm.

Ces deux couches sont déposées par pulvérisation cathodique puis localisées avec les techniques standards de la microélectronique.

La couche active présente les mêmes caractéristiques que dans l'exemple précédent, l'accepteur pouvant être une molécule de type dérivé du fullerene de type PCBSD. De plus, La couche active est recuite à 160°C pendant 30 min afin de la réticuler et de la rendre insoluble.

Dans un premier temps, l'empilement est trempé dans une solution de gravure du ZnO (par exemple la solution commercialisée sous la dénomination TE100 par Transène) pendant 30 s.

Dans un deuxième temps, l'empilement est trempé dans une solution de gravure du Cr. (par exemple Chrome Etch (Acide Nitrique (5-10%) / Diammonium hexanitratocerate (20-25%), avec une vitesse de gravure de V=10 nm/min)

Cette couche active est ensuite rincée abondamment à l'eau désionisée puis séchée.

Une résine du type SU-8 est déposée par spin-coating sur la couche active pour obtenir une épaisseur de 2 µm. Cette couche est alors recuite à 100°C pendant 1 min.

Elle est ensuite insolée par la face arrière du substrat, avec une longueur d'onde de 365 nm et une dose de 100 mJ/cm². La résine est ensuite développée dans les zones non insolées, pendant 90 s et à l'aide d'un développeur à base de PGMEA.

En dernier lieu, l'électrode 5 (anode) est déposée. Elle comporte une couche d'interface de 100 nm en PEDOT-PSS, sur laquelle est déposée une couche semi-transparente de nanofil d'Ag sous la forme d'un réseau percolant en 2D.

Un exemple de la variante du premier mode de mise en oeuvre illustrée sur les figures 7 à 12 va maintenant être décrit. Cette variante permet de réaliser des photodiodes organiques sur un substrat rigide en verre.

La première électrode (cathode) 2 est réalisée en un empilement de trois couches AZO/Ag/AZO, ces trois couches présentant respectivement une épaisseur de 600 nm, 10 nm et 600 nm.

Cette première électrode 2 est déposée par pulvérisation cathodique puis localisée avec les techniques standards de la microélectronique.

La couche active 3 présente les mêmes caractéristiques que celles du premier exemple décrit précédemment.

L'empilement est ensuite trempé dans une solution de gravure de l'AZO (par exemple la solution commercialisée sous la dénomination TE100 par la société Transène), puis dans une solution de gravure de l'Ag (par exemple, une solution du type 4CH₃COH + 1 NH₄OH + 1H₂O₂, avec une vitesse de gravure de v=6nm/s) et enfin, pendant 60 s dans une solution de gravure de l'AZO.

La couche 3 est ensuite rincée abondamment à l'eau désionisée, puis séchée.

Une couche tampon ou de passivation réalisée en Cytop® est déposée sur la couche active 3 par spin-coating, pour obtenir une épaisseur de 300 nm.

La surface de la couche 3 est activée au plasma pour la rendre mouillante.

Une résine du type SU8 est déposée sur la couche pour obtenir une épaisseur de 1 µm.

La résine est ensuite insolée par la face arrière du substrat, avec une longueur d'onde de 365 nm et une dose de 100 mJ/cm².

La résine est enfin développée à l'aide d'un développeur à base de PGMEA dans les zones non insolées, pendant 40 s.

La couche tampon 6 est gravée en la trempant pendant 30 s dans un solvant fluoré (par exemple commercialisé sous la dénomination CT-SOLV 180) et en utilisant les plots de résine comme masque.

La deuxième électrode 5 est réalisée comme décrit dans le premier exemple.

Il convient de noter, que dans le cadre de ce premier mode de mise en oeuvre du procédé, peut être omise l'étape (c) dans laquelle est éliminée localement la première électrode, par attaque chimique à travers les zones non continues de la zone active.

Dans ce cas, la résine est insolée à travers l'électrode 2 et dans les zones correspondant à celles des défauts 30 dans la couche active 3.

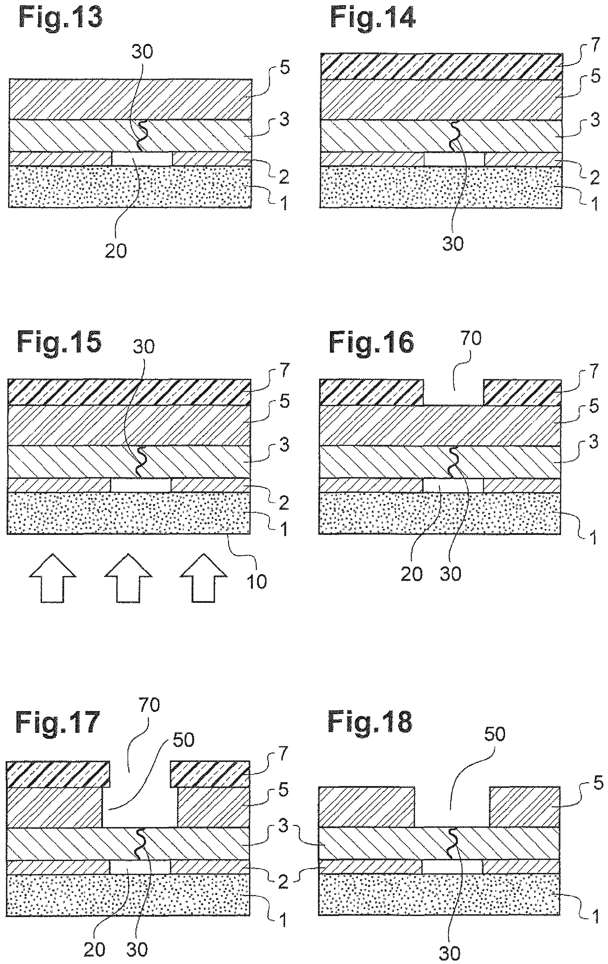

Il est maintenant fait référence aux figures 13 à 18 relatives aux étapes supplémentaires du deuxième mode de mise en oeuvre du procédé selon l'invention. La première électrode (couche 2) est donc opaque.

Ainsi, la figure 13 illustre une étape (g) de ce deuxième mode de mise en oeuvre du procédé selon l'invention, dans laquelle la deuxième électrode 5 est réalisée directement sur la couche active 3, après les étapes (a) à (c) illustrées aux figures 1 et 2.

Cette deuxième électrode 5 peut présenter les mêmes caractéristiques que celle décrite en référence à la figure 6, en précisant qu'elle doit être au moins transparente à la longueur d'onde de la résine. Elle peut également être déposée en utilisant les mêmes techniques.

L'électrode 5 peut être conçue de façon à couper la longueur d'onde de la résine mais sans couper la longueur d'onde d'absorption de la photodiode.

En pratique, ceci signifie que, dans ce deuxième mode de mise en oeuvre du procédé, l'étape (g) est réalisée entre les étapes (c) et (d), cette étape (d) étant maintenant décrite en référence à la figure 14.

Cette étape (d) consiste à déposer une couche 7 d'une résine positive sur la deuxième électrode 5.

Cette couche 7 peut être déposée par évaporation ou, de préférence, par voie liquide, et notamment par slot-die, spin-coating ou spray coating.

L'épaisseur de cette couche 7 est comprise entre 10 nm et 10 µm et, de préférence, entre 0,2 µm et 5 µm.

Cette résine peut être une résine commercialisée sous les dénominations Shipley S1818, Shipley S1814, Shipley S1828, Shipley Megaposit SPR220, série AZ9260 ou AZTX1311-DUV par la société Microchemicals.

La figure 15 illustre une autre étape (e) au cours de laquelle la résine est insolée à travers la face arrière 10 du substrat. En conséquence, elle sera insolée dans les zones où la première électrode 2 n'est pas présente et notamment dans les zones 20 dans lesquelles l'électrode 2 a été gravée.

Dans la mesure où l'électrode 2 est localisée spatialement, il existe des zones autour de l'électrode 2 qui peuvent être transparentes à la longueur d'onde de la résine. En conséquence, la résine sera insolée dans les zones autour de l'électrode 2.

Les conditions d'insolation de cette couche de résine sont identiques à celles qui ont été décrites pour la couche de résine 5 décrite en référence aux figures 3 à 6 et ne seront pas décrites en détail.

La figure 16 illustre l'étape (f) du procédé au cours de laquelle la couche 7 de résine est développée.

Cette étape est réalisée à l'aide d'un développeur qui est orthogonal aux couches sous-jacentes et en particulier, à la couche active 3 et à la deuxième électrode 5.

A titre d'exemple, on peut citer les développeurs commercialisés sous la dénomination MF319 (Shipley), AZ® 726 MIF (Clariant), MF-26A (Shipley).

Ainsi, la figure 16 montre qu'à l'issue de l'étape (f), la couche 7 de résine présente des zones ou trous 70 situés au-dessus des défauts 30 de la couche active 3, dans laquelle la résine est absente. En pratique, au niveau de ces défauts 30 et de part et d'autre de l'ensemble constitué par la couche active 3 et la deuxième électrode 5, aucun matériau n'est présent, du fait de l'existence des zones 20 et 70.

La figure 17 illustre une étape (h) de gravure de la deuxième électrode 5.

Cette gravure est effectuée dans les trous 70 formés dans la couche de résine 7.

Cette étape de gravure est réalisée par voie chimique et/ou physique.

La voie chimique consiste à utiliser des solutions de gravure ou des solvants. La voie physique consiste à utiliser des plasmas de type RIE par exemple.

La gravure pourra s'arrêter, soit au niveau de la surface supérieure de la couche active 3, soit dans l'épaisseur de la couche active 3, soit au niveau de la première électrode 2 après gravure complète de la couche active.

La figure 17 illustre la situation dans laquelle la gravure s'arrête au niveau de la surface supérieure de la couche active 3. Elle conduit à former des ouvertures 50 dans la deuxième électrode 5.

La figure 17 montre que la deuxième électrode 5 est localisée principalement dans les zones en regard de celles où la première électrode 3 est présente.

En d'autres termes, grâce au dépôt de la couche de résine 7, il a été possible de graver la deuxième électrode 5 dans les régions entourant les zones 30 de défauts. Ainsi, ces zones 30 sont isolées électriquement à la fois de la première électrode 2 grâce à la formation des ouvertures 20 et de la deuxième électrode 5 grâce aux ouvertures 50.

La figure 18 illustre une étape (i) supplémentaire de ce procédé consistant à retirer la résine après l'étape (h) de gravure.

Cette étape est réalisée grâce à un solvant orthogonal aux couches sous-jacentes, par exemple de l'acétone.

Cette étape est optionnelle.

Il convient de noter que, dans le cadre de ce deuxième mode de mise en oeuvre du procédé, peut être également omise l'étape (c) décrite en référence à la figure 2, la résine étant isolée à travers l'électrode 2, et dans les zones correspondant aux défauts 30 dans la couche active 3.

Dans une variante de mise en oeuvre du procédé illustré aux figures 13 à 18, une couche de passivation est déposée sur la deuxième électrode 5, c'est-à-dire entre les étapes (g) et (d).

Cette couche de passivation a pour fonction de protéger de la résine, à la fois la première électrode 2, la couche active 3 et l'électrode 5.

Elle peut être conductrice ou isolante.

Elle doit présenter la propriété de laisser passer la longueur d'onde d'insolation de la résine.

Ainsi, cette couche de passivation peut être réalisée en un métal fin (<15 nm), par exemple Ag, Au, Al ou Ti ou un matériau diélectrique déposé par évaporation (par exemple Parylène® ou métaux), par PECVD, CVD, ALD, ou déposé en solution (par exemple polystyrène, polyvinylphénol, Cytop, cyclooléfine ou PMMA).

Cette couche de passivation sera gravée par voie chimique ou par voie physique entre l'étape (f) de développement de la résine illustrée à la figure 16 et l'étape (h) de gravure illustrée à la figure 17.

Ce deuxième mode de mise en oeuvre du procédé présente les avantages suivants par rapport au premier mode de mise en oeuvre décrit en référence aux figures 1 à 12.

Tout d'abord, il permet d'utiliser des résines positives dont le choix est plus large que les résines négatives.

De surcroît, il est plus facile de déposer la couche de résine sur la deuxième électrode 5 que sur la couche active. En effet, les résines sont dans des solvants organiques qui peuvent dissoudre le matériau constituant la couche active. Par contre, les différents types d'électrode 5 (métal, oxyde métallique, polymères conducteurs...) ne sont pas ou peu sensibles aux solvants organiques.

Enfin, la deuxième électrode 5 permet de protéger la couche active des solvants de la résine qui sont utilisés aux étapes (f) et (i).

Un exemple de ce second mode de mise en oeuvre du procédé selon l'invention va maintenant être décrit.

Il conduit à la réalisation de photodiodes organiques sur un substrat rigide en verre.

La première électrode 2 est réalisée en or et présente une épaisseur de 100 nm.

Cette première électrode 2 est déposée par pulvérisation cathodique puis localisée avec les techniques standards de la microélectronique.

L'électrode 2 est ensuite recouverte d'une couche de PEIE présentant une épaisseur de 20 nm qui est déposée par spin-coating. Cette couche est rincée abondamment à l'eau désionisée pour ne laisser qu'une monocouche de PEIE absorbée en surface de l'électrode 2.

Ensuite, une couche active 3 de type hétérojonction volumique d'épaisseur d'environ 150 nm est déposée sur toute la surface de l'électrode 2 par spin-coating, ou par d'autres techniques d'impression du type slot die, sérigraphie, héliogravure, jet d'encre ou spray.

La couche active est un mélange donneur/accepteur, le donneur pouvant être un polymère conjugué de type PCPDTBT et l'accepteur une molécule de type dérivée du fullerene de type 60PCBM. Le donneur et l'accepteur ont un ratio de 1:1.5 dans le mélange.

L'empilement est ensuite trempé dans une solution de gravure de l'or pendant 10 min.

La solution de gravure est un mélange commercial à base de Kl/l2 (par exemple du type VOLUSOL, qui permet de graver 100 nm de Au en 100 s).

La couche active 3 est ensuite rincée abondamment à l'eau désionisée puis séchée.

La deuxième électrode 5 (anode) est ensuite déposée. Elle est composée une couche d'interface de 100 nm en PEDOT-PSS, sur laquelle est déposée une couche dont l'épaisseur est de 8 nm d'Ag évaporé.

Une couche de résine commercialisée sous la dénomination S1818 par la société Shipley est déposée sur la deuxième électrode 5 à la toumette.

Cette couche présente une épaisseur de 1 µm.

La résine est ensuite insolée par la face arrière 10 du substrat, avec une longueur d'onde de 365 nm et une dose de 100 mJ/cm². La résine est alors développée à l'aide du développeur commercialisé sous la dénomination MF319 pendant 40 s.

L'électrode 5 est ensuite gravée entièrement à l'aide d'un plasma oxygène en RIE (Reactive Ion Ecthing).

En dernier lieu, la résine est éliminée en étant plongée pendant 30 s dans un bain d'acétone.

Il a été précédemment indiqué au regard de la figure 17 que la deuxième électrode 5 était principalement localisée dans des zones en regard de celles dans lesquelles la première électrode 2 était présente.

Les conséquences vont être différentes pour des dispositifs unitaires, comme des diodes unitaires, ou pour des matrices de pixels.

Pour les diodes unitaires qui sont de taille macroscopique (diamètre ~1 mm), la conséquence est que le contact électrique sur l'électrode 5 devra se faire sur la surface active de la diode qui correspond à la zone de recouvrement entre l'électrode 5 et l'électrode 2.

Dans le cas où l'on souhaite déporter le contact électrique sur l'électrode 5, il sera nécessaire de rajouter une troisième couche conductrice, ou troisième électrode qui va connecter l'électrode 5 à un plot de reprise de contact électrique. La troisième électrode connecte l'électrode 5 sur une faible surface de la diode afin que l'électrode 5 ne vienne pas court-circuiter les défauts initialement passivés.

Pour une matrice de pixels, à l'issue de l'étape (h) de gravure, la deuxième électrode 5 ne forme plus une couche continue. En conséquence, les pixels sont déconnectés les uns des autres.

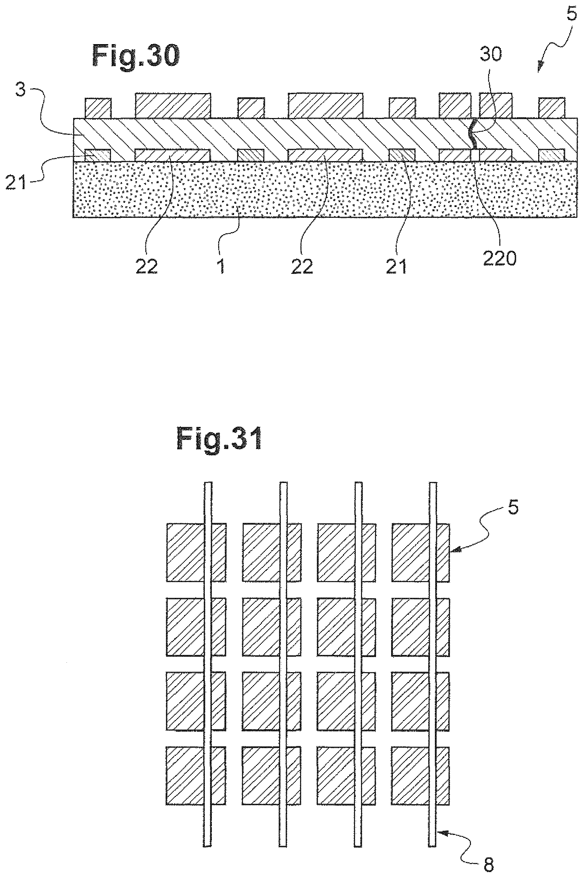

La figure 30 est une vue en coupe qui représente une telle matrice de pixels.

Ainsi, la figure 30 illustre une ligne de plots 22 de la première électrode 2 disposés selon une ligne, entre lesquels sont disposés des plots 21 de ligne.

Les plots 22 de la première électrode et les plots 21 de ligne (ou de colonne) sont des zones opaques.

Ainsi, après la mise en oeuvre des étapes (d) à (h), on obtient la matrice illustrée à la figure 30.

Elle montre un défaut 30 dans la couche active 3 et une zone 220 d'un plot 22 en regard du défaut 30, dans laquelle le plot a été gravé.

Dans le cas des matrices, il est donc nécessaire de prévoir une étape supplémentaire après l'étape (i) afin de faire en sorte que l'électrode 5 redevienne continue.

Une première solution consiste à redéposer au moins une couche conductrice (de même nature que celle de l'électrode 5 ou non), afin de reconnecter tous les plots de l'électrode 5 entre eux et d'obtenir une couche conductrice continue.

La figure 31 illustre cette couche conductrice 8 et montre que cette couche est localisée, dans la mesure où elle consiste en des lignes conductrices reliant électriquement les plots de la deuxième électrode 5.

En pratique, il est nécessaire que cette couche conductrice 8 soit localisée pour éviter qu'elle ne court-circuite la première électrode 2 à travers les défauts présents dans la couche active 3.

Une autre variante consiste à rendre opaque à la longueur d'onde d'insolation de la résine, les espaces situés entre les plots de la première électrode 2.

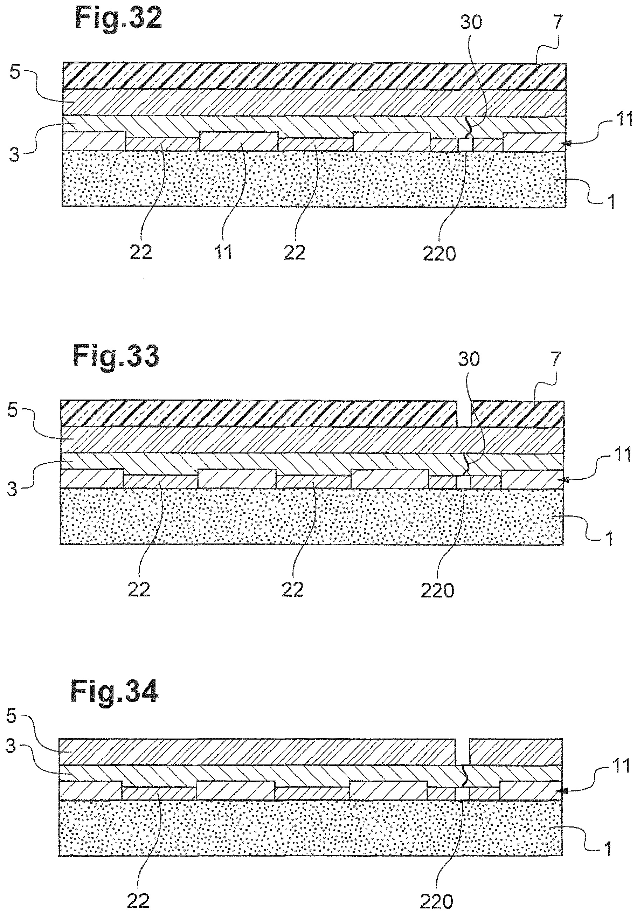

Ainsi, comme l'illustre la figure 32, une couche 11 d'un matériau opaque à cette longueur d'onde peut être déposée entre les plots 22 de la première électrode 2, les étapes (g) et (d) étant réalisées comme cela a été décrit en référence aux figures 13 et 14.

Pour une longueur d'onde de l'ordre de 365 nm, cette couche localisée 10 peut être réalisée en polyimide, par exemple commercialisé sous la dénomination NISSAN SE5291, ou une résine négative de type SK-3000L (Fujifilm), cette couche 10 présentant une épaisseur de 0,1 µm à 5 µm.

Cette couche opaque 11 fait office de masque. Ainsi, lors de l'étape (e), la couche de résine ne peut être insolée que dans la zone située au-dessus des plots de la première électrode 2 et dans la mesure où des défauts sont présents.

La figure 33 illustre la matrice après l'étape (e) d'insolation de la résine à travers le substrat 1 et l'étape (f) de développement de la résine. Ces étapes (e) et (f) sont réalisées comme décrit en référence aux figures 15 et 16.

La figure 34 illustre cette matrice après les étapes (h) de gravure de la deuxième électrode 5 et (i) de retrait de la résine, telles que décrites en référence aux figures 17 et 18.

La figure 34 montre que, même après cette étape de gravure de la deuxième électrode 5, cette dernière reste sous la forme d'une couche continue. Il n'est donc pas nécessaire de déposer une troisième électrode localisée, telle que celle illustrée sur la figure 31.

Cette variante est avantageusement utilisée pour les matrices présentant un faible pas de répétition entre les pixels.

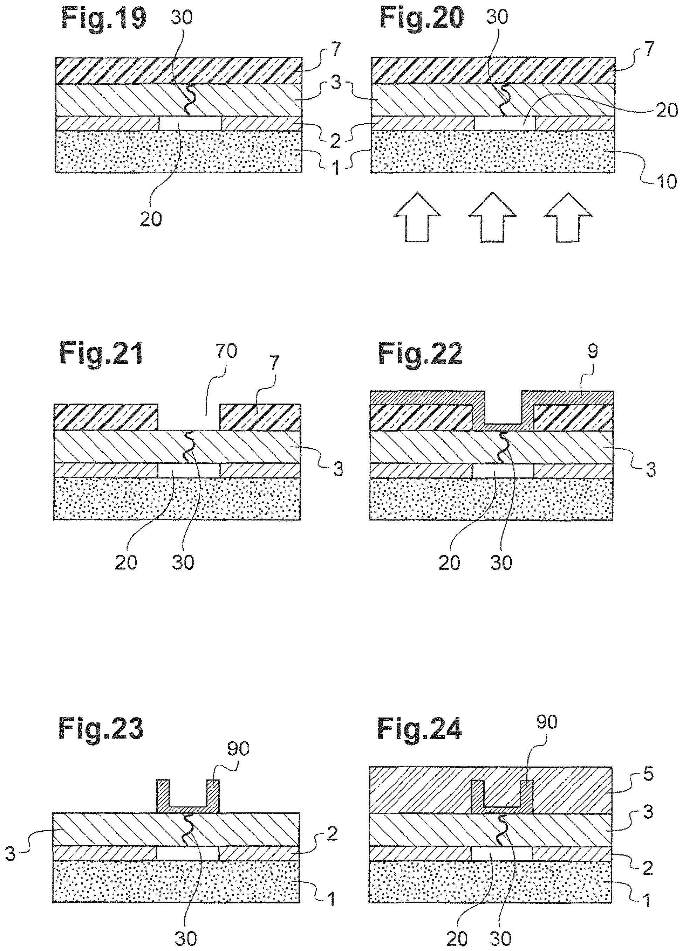

Il est maintenant fait référence aux figures 19 à 24 qui illustrent les étapes supplémentaires correspondant au troisième mode de mise en oeuvre du procédé, non conforme à la présente invention.

La figure 19 illustre une autre étape (d) de ce troisième mode de mise en oeuvre du procédé, dans laquelle une couche 7 d'une résine positive est déposée sur la couche active 3, après les étapes (a) à (c) illustrées aux figures 1 et 2.

Cette couche de résine peut présenter les mêmes caractéristiques que celle décrite en référence à la figure 14.

Elle peut également être déposée en utilisant les mêmes techniques.

La couche 7 de résine ne sera donc pas décrite plus en détail.

Les figures 20 et 21 illustrent les étapes (e) d'insolation et (f) de développement de la couche de résine.

Ces étapes (e) et (f) peuvent être réalisées comme cela a été décrit en référence aux figures 15 et 16.

Ces deux étapes ne seront donc pas décrites plus en détail.

La figure 21 montre, qu'à l'issue de l'étape (f), des trous 70 sont formés dans la couche 7, ces trous étant en vis-à-vis des zones 20 dans lesquelles l'électrode 2 a été gravée lors de l'étape (c).

La figure 22 illustre une étape (j) supplémentaire de ce procédé consistant à déposer une couche 9 de passivation, isolante électriquement, sur la couche de résine 7 et la couche active 3, au niveau des trous 70 réalisés dans la couche de résine 7.

Cette couche de passivation peut être un polymère isolant de type polymère fluoré ou polyoléfine cyclique, ou une couche déposé par ALD (par exemple un oxyde métallique du type Al₂O₃, un nitrure métallique du type SiN), ou une couche déposée par évaporation (par exemple du Parylène®).

Dans la mesure où cette couche 9 se conforme à la surface de l'empilement, elle permet de recouvrir les défauts 30 de la couche active 3.

La figure 23 illustre une étape complémentaire (k) de ce procédé consistant à retirer localement la couche 9 de passivation par le retrait de la résine 7. Ce retrait est effectué par dissolution de résine en trempant la résine dans un de ses solvants (type acétone), méthode connue en anglais sous le nom de : « lift off ». Dans la suite de la description, les termes anglais seront à nouveau utilisés. Le solvant va s'infiltrer sous la couche 9, dissoudre la résine et emporter la couche 9 dans les zones dissoutes.

Afin de favoriser cette étape de retrait, la couche de passivation pourra être non continue et ouverte dans des zones de l'échantillon en dehors de l'électrode 2. Ces ouvertures pourront se faire de manière additive, par localisation directe lors du dépôt de la couche de passivation, ou de manière soustractive, par ablation laser par exemple.

La figure 23 montre qu'après cette étape (k), sont obtenus des plots 90 en matériau isolant électriquement qui sont situés au-dessus des zones 20 gravées de la couche 2 et des défauts présents dans la couche active 3. Ces plots 90 permettent d'isoler électriquement les zones 30 susceptibles de créer des courants de fuite électriques dans l'empilement.

La figure 24 illustre la dernière étape (g) de ce procédé au cours de laquelle la deuxième électrode 5 est déposée sur la couche active 3.

Cette deuxième électrode 5 peut présenter les mêmes caractéristiques que celles décrites en référence à la figure 6. Elle peut également être déposée en utilisant les mêmes techniques.

Cette deuxième électrode 5 ne sera donc pas décrite plus en détail.

Il convient de noter que, dans le cadre de ce troisième mode de mise en oeuvre du procédé, peut être également omise l'étape (c) décrite en référence à la figure 2, la résine étant isolée à travers l'électrode 2 et dans les zones correspondant aux défauts 30 dans la couche active 3.

A titre de variante, une autre couche de passivation peut être déposée entre les étapes (c) et (d). Cette couche de passivation est donc déposée sur la couche active 3 et sert à protéger la première électrode 2 et la couche active 3 de la résine.

Cette couche de passivation doit être isolante électriquement et présenter la propriété de laisser passer la longueur d'onde d'insolation de la résine.

Elle peut être réalisée en un matériau diélectrique déposé par évaporation (par exemple du Parylène®), par PECVD, CVD, ALD, ou déposé en solution (polystyrène, polyvinylphénol ou Cytop® ou cyclooélfine...).

Cette couche de passivation est ensuite gravée par voie chimique ou par voie physique entre les étapes (k) et (g) illustrées aux figures 23 et 24.

Un exemple de ce troisième mode de mise oeuvre du procédé va maintenant être décrit. Il permet de réaliser des photodiodes organiques sur un substrat rigide en verre.

La première électrode 2 (l'anode) est réalisée en chrome et présente une épaisseur de 10 nm.

Elle est déposée par pulvérisation cathodique puis localisée avec les techniques standards de la microélectronique. L'électrode 2 est décapée à l'aide d'un traitement plasma RIE.

Une couche active 3 de type hétérojonction volumique et d'une épaisseur de 150 nm est déposée sur toute la surface de la première électrode 2 par spin-coating ou d'autres techniques d'impression du type slot die, sérigraphie, héliogravure, jet d'encre ou spray.

La couche active est un mélange donneur/accepteur, le donneur pouvant être un polymère conjugué de type PBDTTT-C et l'accepteur une molécule de type fullerene C60. Le donneur et l'accepteur ont un ratio de 1:2 dans le mélange.

L'empilement est ensuite trempé dans une solution de gravure du Cr pendant 10 min. La solution de gravure est par exemple un mélange du type : 1 g de Ce(SO₄)₂-2(NH₄)2-SO₄-2H₂0 +5 ml HNO₃ + 25 ml H₂O, la gravure est réalisée à 28°C et la vitesse de gravure est de 8.5 nm/min.

La couche 3 est ensuite rincée abondamment à l'eau désionisée puis séchée. Une couche de résine du type commercialisée sous la dénomination S1814 par la société Shipley est déposée sur la couche active. Elle est ensuite insolée par la face arrière du substrat avec une longueur d'onde de 365 nm et une dose de 80 mJ/cm².

La couche de résine est développée à l'aide du développeur commercialisé sous la dénomination MF319 (Shipley) pendant 40 s.

Une couche de passivation d'Al₂O₃ présentant une épaisseur de 50 nm est déposée par ALD. La couche de passivation est ouverte par endroit sur des surfaces de diamètre inférieur à 50 µm, dans des zones hors de l'électrode 2, et en utilisant une ablation à l'aide d'un laser excimer. Ces zones ouvertes vont permettre au solvant de dissoudre la résine, de s'infiltrer à travers la couche tampon et de réaliser l'étape de lift off.

La résine est ensuite strippée dans un bain d'acétone pendant 1 min.

L'électrode 5 (la cathode) composée de PEDOT/PSS et présentant une épaisseur de 50 nm est finalement déposée par spin-coating.

Les figures 25 à 28 illustrent une variante de ce troisième mode de mise en oeuvre du procédé.

Cette variante intervient après les étapes (a) à (c) décrites en référence aux figures 1 et 2 et les étapes (d) et (f) décrites en référence aux figures 19 à 21.

Cette variante comporte une étape (I) de gravure de la couche active 3.

Cette étape (I) est illustrée à la figure 25.

Cette gravure est effectuée dans les trous 70 formés dans la couche de résine 7.

Elle est réalisée par voie liquide, par exemple par dissolution dans des solvants, ou par voie physique, en utilisant des plasmas de type RIE notamment.

Ainsi, comme le montre la figure 25, l'empilement est complètement évidé, au niveau des zones 20 de la première électrode 2 qui ont été gravées.

La figure 26 illustre l'étape (j) suivante dans laquelle une couche de passivation 9 est déposée sur l'empilement.

Cette couche 9 peut présenter les mêmes caractéristiques que la couche de passivation décrite en référence à la figure 22. Elle peut être également déposée en utilisant les mêmes techniques. Elle ne sera donc pas décrite plus en détail.

La figure 26 montre que cette couche 9 se conforme à la surface de l'empilement et qu'elle vient donc en contact avec le substrat 1 dans les zones 20 de la première électrode 2 qui ont été préalablement gravées.

La figure 27 illustre l'étape (k) de retrait de la résine présente dans la couche 7.

Ce retrait de la résine peut être réalisé comme cela a été précédemment décrit au regard de la figure 23 et il ne sera pas décrit plus en détail.

La figure 27 montre que, grâce au dépôt de la couche de résine 7, la couche active 3 a pu être gravée au niveau des défauts 30 qui ont donc été éliminés. Par ailleurs, la couche de passivation 9 permet d'isoler la première électrode 2 et la deuxième électrode 5.

La figure 28 illustre l'étape (g) dans laquelle la deuxième électrode conductrice 5 est déposée sur l'empilement.

Cette étape (g) peut être réalisée comme cela a été précédemment décrit au regard de la figure 6 et elle ne sera donc pas décrite plus en détail.

Il est également possible de combiner les deux variantes de ce troisième mode de mise en oeuvre du procédé, en prévoyant une autre couche de passivation sur la couche active 3, cette couche de passivation étant gravée avant l'étape (I) de gravure de la couche active, telle qu'illustrée à la figure 25.

Il convient de noter que, dans le cadre de ce troisième mode de mise en oeuvre du procédé, si la première électrode 1 est conçue de façon à couper la longueur d'onde de la résine, sans couper la longueur d'onde d'absorption de la photodiode, la transmittance de la deuxième électrode 5 n'a pas d'importance.

Un exemple de mise en oeuvre de la variante décrite en référence aux figures 25 à 28 va maintenant être décrit.

Il permet de réaliser des photodiodes organiques sur un substrat rigide en verre.

La première électrode 2 (l'anode) est réalisée en or et présente une épaisseur de 100 nm.

Elle est déposée par pulvérisation cathodique puis localisée avec les techniques standards de la microélectronique.

Une couche active 3 de type hétérojonction volumique d'une épaisseur de 10 nm est déposée sur toute la surface de l'électrode 2 par spin-coating ou d'autres techniques d'impression types slot die, sérigraphie, héliogravure, jet d'encre ou spray.

La couche active est un mélange donneur/accepteur, le donneur pouvant être un polymère conjugué de type TFB et l'accepteur une molécule de type dérivée du fullerene de type PCBSD. Le donneur et l'accepteur ont un ratio de 1:2 dans le mélange.

La couche active est recuite à 160°C pendant 30 min afin de réticuler et de devenir insoluble.

L'empilement est ensuit trempé dans la solution de gravure de l'Au pendant 10 min.

La solution de gravure est un mélange commercial à base de Kl/l2. (par exemple du type VOLUSOL ; une gravure de 100 nm de Au étant obtenue en 100 s).

La couche 3 est ensuite rincée abondamment à l'eau désionisée puis séchée.

Une couche de résine du type commercialisée sous la dénomination S1818 par la société Shipley est déposée sur la couche active, puis insolée par la face arrière du substrat avec une longueur d'onde de 365 nm et une dose de 80 mJ/cm².

La couche de résine est développée à l'aide du développeur commercialisé sous la dénomination MF319 pendant 40 s.

La couche active est ensuite gravée à l'aide d'un plasma Argon en RIE.

Une couche de passivation de 50 nm d'Al₂O₃ présentant une épaisseur de 50 nm est ensuite déposée par ALD. La couche de passivation est ouverte par endroit sur des surfaces de diamètre inférieur à 50 µm, dans des zones hors de l'électrode 1, et en utilisant une ablation à l'aide d'un laser excimer. Ces zones ouvertes vont permettre au solvant de dissolution de la résine de s'infiltrer à travers la couche tampon et de réaliser l'étape de lift off.

La résine est ensuite strippée dans un bain d'acétone pendant 1 min.

L'électrode 5 (la cathode) composée d'une couche d'Al avec une épaisseur de 3 nm et d'une couche d'Ag avec une épaisseur de 7 nm est finalement déposée par évaporation sous vide.

Il convient de noter que dans tous les modes de mise en oeuvre du procédé, la couche de résine peut être déposée sur toute la surface de l'empilement ou seulement dans des zones localisées. Ce dépôt localisé pourra être réalisé à l'aide d'un masque.

A la lecture des différents modes de mise en oeuvre du procédé, on comprend que ce procédé permet de résoudre le problème des courants de fuite électriques parasites à travers une couche semi-conductrice organique d'un empilement, en passivant électriquement les zones fragiles de cette couche organique, qu'il s'agisse de trous ou de zones de morphologies différentes.

Pour cela, le procédé peut prévoir, comme dans le document FR-2 991 505, de graver localement une zone d'électrode sous la couche active, à travers les défauts de cette couche. Cette étape (c) de gravure locale rend le procédé encore plus efficace pour passiver les défauts de la couche active.

De plus, ce procédé prévoit le dépôt d'une résine positive ou négative qui est insolée à travers l'électrode présente sous la couche active.

Ainsi, le procédé permet d'ouvrir une résine positive ou de déposer une résine négative, précisément au-dessus des zones fragiles, à l'origine des courants de fuites électriques. L'ouverture ou le dépôt de la résine est ainsi auto-indexée sur les défauts présents sur la couche active.

La résine permet, grâce à des étapes spécifiques, d'isoler électriquement les défauts susceptibles de créer des courants de fuites électriques dans l'empilement, en les réparant localement.

De façon générale, le premier mode de mise en oeuvre constitue un mode privilégié. En effet, c'est ce procédé qui comporte le moins d'étapes et qui est le plus facile à mettre en oeuvre. En particulier, il ne comporte pas d'étape de gravure de la deuxième électrode 5 ou de la couche active 3 qui sont, de surcroît, des étapes délicates à réaliser. Enfin, ce procédé est le mieux adapté à l'obtention de matrices de pixels.

Le procédé selon l'invention pourra avantageusement être utilisé pour augmenter les performances et diminuer les défauts des dispositifs électroniques organiques utilisés dans des composants discrets ou dans des systèmes plus complexes du type matrices passives ou actives. Ces dispositifs pourront être du type organique ou hybride organique/inorganique.

Il pourra notamment s'agir de diodes redresseuses de courant, de cellules solaires, de photodiodes, de capacité, de mémoires, de laser, de diodes électroluminescentes ou de transistors à effet de champ.

Les signes de référence insérés après les caractéristiques techniques figurant dans les revendications ont pour seul but de favoriser la compréhension de ces dernières et ne sauraient en limiter la portée.

## Revendications

1. Procédé de réalisation d'un empilement du type première électrode/couche active/deuxième électrode destiné à un dispositif électronique notamment du type photodétecteur organique ou cellule solaire organique, comportant les étapes suivantes :
(a) dépôt d'une première couche (2) de matériau conducteur sur la face avant d'un substrat, pour former la première électrode,
(b) dépôt d'une couche active (3), sous la forme d'une couche mince semi-conductrice organique, cette couche comportant des zones non continues,
(d) dépôt d'une couche de résine (7) sur la face de l'empilement opposée au substrat, lequel est au moins partiellement transparent,
(e) insolation de la couche de résine (7) par la face arrière (10) dudit substrat, la première électrode (2) étant opaque à la longueur d'onde utilisée pour l'insolation de la couche de résine (7), la résine (7) étant insolée dans des zones correspondant à des zones où la première électrode (2) n'est pas présente,
(f) développement de la couche de résine
(g) dépôt d'une deuxième couche (5) de matériau conducteur pour former la deuxième électrode conductrice
**caractérisé en ce que** : la résine (7) est positive, l'étape (f) conduisant à la formation de trous (70) dans la couche (7) de résine au niveau des zones non continues (30), et l'étape (g) étant réalisée entre les étapes (b) et (d), une étape (h) de gravure de la deuxième électrode conductrice (5) étant réalisée après l'étape (f).

2. Procédé selon la revendication 1, comportant une étape (i) supplémentaire consistant à retirer la résine (7) après l'étape (h) de gravure.

3. Procédé selon la revendication 1 ou 2, comportant une étape supplémentaire consistant à déposer une couche de passivation sur la deuxième électrode conductrice, avant l'étape (d) de dépôt de la couche (7) de résine.

4. Procédé selon une des revendications 1 à 3, dans lequel une étape (c) d'élimination locale par attaque chimique de la première couche conductrice, à travers les zones non continues (30) de la couche active, est réalisée après l'étape (b).

## Patentansprüche

1. Verfahren zur Herstellung eines Stapels vom Typ erste Elektrode/aktive Schicht/zweite Elektrode, welcher für eine elektronische Vorrichtung bestimmt ist, insbesondere vom Typ organischer Lichtdetektor oder organische Solarzelle, welches folgende Schritte beinhaltet:
(a) Ablagern einer ersten Schicht (2) leitfähigen Materials auf der Vorderseite eines Substrates zum Bilden der ersten Elektrode,
(b) Ablagern einer aktiven Schicht (3), in Form einer dünnen organischen Halbleiterschicht, wobei diese Schicht nicht durchgängige Bereiche beinhaltet,
(d) Ablagern einer Harzschicht (7) auf der dem Substrat, welches mindestens teilweise transparent ist, abgewandten Seite des Stapels,
(e) Besonnen der Harzschicht (7) über die rückwärtige Seite (10) des Substrates, wobei die erste Elektrode (2) auf der Wellenlänge, eingesetzt zum Besonnen der Harzschicht (7), undurchsichtig ist, wobei das Harz (7) besonnt wird in Bereichen, die den Bereichen, wo die erste Elektrode (2) nicht anwesend ist, entsprechen.
(f) Entwickeln der Harzschicht,
(g) Ablagern einer zweiten Schicht (5) leitfähigen Materials zum Bilden der zweiten leitfähigen Elektrode,
**dadurch gekennzeichnet, dass**:
das Harz (7) positiv ist, wobei der Schritt (f) zum Bilden von Löchern (70) in der Harzschicht (7) im Bereich der nicht durchgängigen Bereiche (30) führt, und der Schritt (g) zwischen den Schritten (b) und (d) erfolgt, wobei ein Schritt (h) des Gravierens der zweiten leitfähigen Elektrode (5) nach dem Schritt (f) erfolgt.

2. Verfahren nach Anspruch 1, welches einen zusätzlichen Schritt (i) beinhaltet, bestehend im Entfernen des Harzes (7) nach dem Schritt (h) des Gravierens.

3. Verfahren nach Anspruch 1 oder 2, welches einen zusätzlichen Schritt beinhaltet, bestehend im Ablagern einer Passivierungsschicht auf der zweiten leitfähigen Elektrode vor dem Schritt (d) des Ablagerns der Harzschicht (7).

4. Verfahren nach einem der Ansprüche 1 bis 3, bei welchem ein Schritt (c) des lokalen Eliminierens durch chemischen Angriff der ersten leitfähigen Schicht durch die nicht durchgängigen Bereiche (30) der aktiven Schicht nach dem Schritt (b) erfolgt.

## Claims

1. A process for producing a stack of a first electrode/active layer/second electrode, which stack is intended for an electronic device, in particular an organic photodetector or an organic solar cell, said process including the following steps:
(a) depositing a first conductor layer (2) on the front side of a substrate, in order to form the first electrode; and
(b) depositing an active layer (3) taking the form of a thin organic semiconductor layer, this layer including discontinuous zones;
(d) depositing a resist layer (7) on that side of the stack which is opposite the substrate, which substrate is at least partially transparent;
(e) exposing the resist layer (7) via the back side (10) of said substrate; the first electrode (2) being opaque at the wavelength used for the exposure of the resist layer (7), the resist (7) being exposed in areas corresponding to areas where the first electrode (2) is not present,
(f) developing the resist layer,
(g) depositing a second conductor layer (5) in order to form the conductive second electrode,
**characterized in that**:
the resist (7) is positive, step (f) leading to the formation of holes (70) in the resist layer (7) level with the discontinuous zones (30), and step (g) being carried out between steps (b) and (d), a step (h) of etching the conductive second electrode (5) being carried out after step (f).

2. The process as claimed in claim 1, including an additional step (i) consisting in removing the resist (7) after the etching step (h).

3. The process as claimed in claim 1 or 2, including an additional step consisting in depositing a passivating layer on the conductive second electrode, before step (d) of depositing the resist layer (7).

4. The process as claimed in one of claims 1 to 3, wherein a step (c) of removing the conductive first layer locally via chemical attack, through the discontinuous zones (30) of the active layer, is carried out after step (b).
